# EUROPEAN PATENT SPECIFICATION

(11) **EP 4 450 461 B1**
(45) Date of publication and mention of the grant of the patent: **15.04.2026**
(21) Application number: 24185460.3
(22) Date of filing: 14.12.2020
(51) Int. Cl.: C01G 39/04, C23C 16/08

(54) **HIGH-PURITY MOLYBDENUM OXYCHLORIDE**
HOCHREINES MOLYBDÄNOXIDCHLORID
OXYCHLORURE DE MOLYBDÈNE À PURETÉ ÉLEVÉE

(30) Priority: 28.02.2020 JP 2020033357
(43) Date of publication of application: 23.10.2024
(62) Divisional of application: 20922237.1
(73) Proprietor: JX Advanced Metals Corporation, Tokyo 105-8417 (JP); Toho Titanium CO., LTD., Chigasaki-shi Kanagawa 253-8510 (JP)
(72) Inventor: TAKAHASHI, Hideyuki, Ibaraki, 319-1535 (JP); TANI, Seiichiro, Kanagawa, 253-8510 (JP); FUKASAWA, So, Kanagawa, 253-8510 (JP)
(74) Representative: Forresters IP LLP

(56) References cited:
- EP-A1- 3 656 741
- EP-A1- 3 738 928
- WO-A1-2020/021786

## Description

### [Technical Field]

The present invention relates to a high-purity molybdenum oxychloride suitable for use as a vapor phase growth material and a chemical reaction catalyst of thin films, and to a manufacturing method therefor.

### [Background Art]

Low-resistance metal materials, which are physically and chemically stable, such as molybdenum (Mo) and tungsten (W) have often been used conventionally for thin films for use as contact plugs, wirings, and diffusion barrier layers under wirings in semiconductor devices and other functional electronic devices. Moreover, thin films made of compounds of these metals, such as nitrides and carbides, are also often used as the diffusion barrier layer. A molybdenum or molybdenum compound thin film is formed by using chemical vapor deposition (CVD) method in which a molybdenum compound is evaporated and gasified as a precursor, and a product thereof is decomposed and reacted on a surface of the substrate to form a thin film.

Moreover, pitch reduction and depth extension of contact plug parts associated with the high integration and high densification of devices in recent years are advancing and metal layers are often formed in a deep hole having a high aspect ratio and, in order to uniformly form a metal layer in the deep hole having this kind of high aspect ratio, an atomic layer deposition (ALD) method is also used to uniformly form a thin metal layer to become a seed layer in the deep hole and a metal layer to become a thick contact plug or wiring is subsequently formed by using CVD method described above or the plating method.

An organic metal compound, metal carbonyl, metal halide or the like can be used as the precursor compound for use upon forming a metal or metal compound based on the CVD method or the ALD method described above. As this kind of conventional technology, there are, for instance, an example of forming a MoS₂ film using a molybdenum chloride (MoCl₅) (Patent Document 1), an example of forming a Mo film using a molybdenum carbonyl (Mo(CO)₆) (Patent Document 2), an example of forming a Mo film using a molybdenum organic compound (Patent Document 3), and an example of forming MoS₂ (Patent Document 4).

Nevertheless, a molybdenum pentachloride (MoCl₅), which is a general molybdenum chloride, is unstable, and is difficult to handle since toxic hydrogen chloride is naturally generated when molybdenum pentachloride is decomposed, and there are problems related to its preservation and storage for use in industrial processes. Moreover, while the foregoing problems will not arise in the CVD method and the ALD method which use a metal carbonyl as its raw material, since a metal carbonyl is in itself toxic and a metal carbonyl containing molybdenum has a low vapor pressure, there are problems in that it is difficult to control the flow rate and pressure of the raw material gas during the CVD or ALD deposition.

Thus, as disclosed in Patent Document 5 or Non-Patent Document 1, there is a method of using a molybdenum oxychloride (MoOCl₂, MoOCl₃, MoOCl₄, MoO₂Cl₂) as the raw material precursor, and performing the CVD deposition of molybdenum or a molybdenum compound. The molybdenum oxychloride itself is a substance conventionally known as a chemical reaction catalyst of organic synthesis or the like, in addition to this kind of CVD raw material, as disclosed in Patent Document 6, Patent Document 7, and Non-Patent Document 2. A molybdenum oxychloride is synthesized by directly chloridating a molybdenum oxide powder with a chlorine gas as described in Non-Patent Document 3. Patent document 8 describes a process for the production of 5N5 molybdenum oxychloride.

### [Prior Art Documents]

### [Patent Documents]

[Patent Document 1] Japanese Unexamined Patent Application Publication No. 2003-225808
[Patent Document 2] Japanese Unexamined Patent Application Publication (Translation of PCT Application) No. 2008-520834
[Patent Document 3] Japanese Unexamined Patent Application Publication No. 2006-097101
[Patent Document 4] Japanese Unexamined Patent Application Publication (Translation of PCT Application) No. H11-507629
[Patent Document 5] Japanese Unexamined Patent Application Publication No. 2000-119045
[Patent Document 6] Japanese Unexamined Patent Application Publication No. 2003-252845
[Patent Document 7] Japanese Unexamined Patent Application Publication No. H08-277263
[Patent Document 8] WO 2020/021786

### [Non-Patent Documents]

[Non-Patent Document 1] K. A. Gesheva et al., Thin Solid Films, Vol.79, 1981, pp. 39-49
[Non-Patent Document 2] Rita G, de Noronha et al., Cat. Commun., Vol.12, 2011, pp. 337-340
[Non-Patent Document 3] Y. Monteil et al., J. Cryst. Growth, Vol. 67, 1984, pp. 595-606

### [Summary of the Invention]

### [Problems to be Solved by the Invention]

A molybdenum oxychloride can be synthesized, for example, by chloridating a raw material powder of a molybdenum oxide (MoO₃) with a chlorine gas (Cl₂). Here, while impurities can be separated to a certain extent by properly managing the synthesis temperature, metal impurities such as tungsten (W) contained as an impurity in the raw material form chlorides and oxychlorides, and they are difficult to remove since they have a high vapor pressure. In particular, there is a problem in that W, which exists in a high concentration in the raw material MoO₃, remains in a high concentration in the molybdenum oxychloride of the final product. An object of the present invention is to resolve the foregoing problems, and provide a high-purity molybdenum oxychloride and a manufacturing method therefor.

### [Means for Solving the Problems]

As a result of intense study, the present inventors discovered that, by providing an impurity trap to an apparatus for synthesizing a high-purity molybdenum oxychloride, chloride of tungsten (W) or the like having a high vapor pressure can be effectively separated, and a high-purity molybdenum oxychloride can be manufactured, and thereby completed the present invention.

Based on the foregoing discovery, one mode of the present invention is a molybdenum oxychloride characterized in having a purity of 99.9995 wt% or higher as recited by claim 1. Note that, in the present disclosure, "molybdenum oxychloride" includes one type among MoOCl₂, MoOCl₃, MoOCl₄, and MoO₂Cl₂. Further, preferred, features are presented in the dependent claims.

### [Effect of the Invention]

According to the present invention, it is possible to separate tungsten (W) and the like, which were difficult to remove during synthesis in the past, and thereby obtain a high-purity molybdenum oxychloride. Furthermore, as a result of using this kind of high-purity molybdenum oxychloride as a precursor in the CVD method and the ALD method, the present invention yields a superior effect of being able to avoid characteristic defects caused by the impurity metals in the thin films used in a semiconductor apparatus.

### [Brief Description of the Drawings]

[Fig. 1]

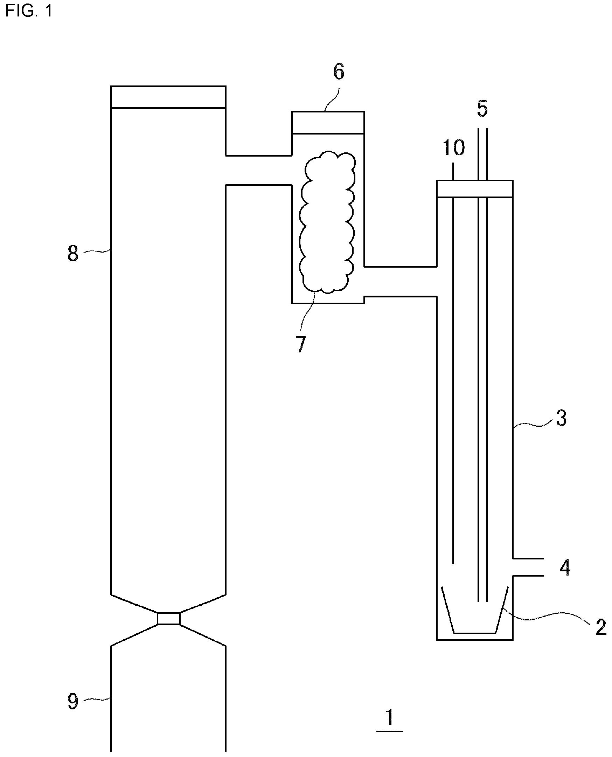

Fig. 1 is a schematic diagram of an apparatus for synthesizing a molybdenum oxychloride.

### [Best Mode for Carrying Out the Invention]

A molybdenum oxychloride can be synthesized by chloridating a molybdenum oxide (MoO₃) powder with a chlorine gas. Nevertheless, a molybdenum oxide powder as a raw material contains a relatively large amount of tungsten (W) and iron (Fe) as impurities, and these metal impurities react with the chlorine gas during synthesis and form oxychlorides, and, since these oxychlorides have a high vapor pressure, gas phase separation was difficult. Thus, conventionally, tungsten and the like caused by the raw material could not be removed, and roughly 10 wt ppm of W was contained in the synthesized molybdenum oxychloride, and the purity excluding W was roughly 5N (99.999 wt%).

When a molybdenum oxychloride containing these types of impurities is used as a precursor of the CVD method or the ALD method, there was a problem in that impurities would remain in the molybdenum compound after the deposition process, and deteriorate the characteristics of the film. In particular, when used as a thin film of a semiconductor layered structure, there was a problem in that the device performance would deteriorate.

Accordingly, an object of the present invention is to provide a high-purity molybdenum oxychloride, and is characterized in that the molybdenum oxychloride according to the present invention has a purity of 99.9995 wt% (5N5) or higher, and preferably has a purity of 99.9999 wt% (6N) or higher, wherein a K content or a W content is less than 1 wt ppm.

In the present disclosure, the purity is obtained by analyzing Ba, W, Ti, Ag, Na, K, Fe, In, Zn, Cu, Cr, and Al based on the ICP-MS method, and subtracting the total content (wt%) thereof from 100 wt%. Note that, when the analytical value of each element is as indicated below, the content of such element is deemed to be 0 (zero) as corresponding to being less than the lower detection limit.
Ba: <0.1 wt ppm, W: <0.1 wt ppm, Ti: <0.1 wt ppm, Ag: <0.1 wt ppm, Na: <0.1 wt ppm, K: <1 wt ppm, Fe: <0.1 wt ppm, In: <0.1 wt ppm, Zn: <0.1 wt ppm, Cu: <0.1 wt ppm, Cr: <0.1 wt ppm, Al: <0.1 wt ppm

When these elements are used as the wiring or the like of an electronic device, since they increase resistivity, generate electromigration, induce diffusion within the device and thereby deteriorate the device performance, they are specific elements which are preferably excluded.

The molybdenum oxychloride according to the present invention has a W (tungsten) content of less than 1 wt ppm, and preferably less than 0.1 wt ppm, or K (potassium) as an alkali metal reduced to be less than 1 wt ppm. Moreover, the molybdenum oxychloride preferably has an Fe (iron) content of less than 0.1 wt ppm. As described above, tungsten and iron are impurities that are included in a molybdenum oxide as a raw material in a relatively large amount. Moreover, since tungsten chloride, ferric chloride and the like formed during synthesis have a high vapor pressure, they are easily mixed into a molybdenum oxychloride of a synthetic material, and, by nature, gas phase separation is difficult. According to the present invention, it is possible to cause these impurities, which are difficult to remove, to be an extremely low content.

The molybdenum oxychloride according to an embodiment of the present invention preferably has a Na (sodium) content of less than 0.1 wt ppm. Sodium reacts with chlorine of the reaction gas or other impurity components and forms various salts such as sodium chloride, and sometimes gets mixed in. Since sodium as an alkali metal particularly deteriorates the device performance in the wirings and the like of an electronic device, the content thereof is preferably reduced to be less than 0.1 wt ppm.

The manufacturing method of a molybdenum oxychloride according to an embodiment of the present invention is now explained in detail.

A MoO₃ (molybdenum trioxide) powder is prepared as the raw material. A high-purity MoO₃ raw material is preferably used, and, excluding tungsten, preferably has a purity of 3N (99.9 wt%) or higher, and more preferably has a purity of 4N (99.99 wt%) or higher. From the perspective that a raw material can be easily charged by passing it through a supply tube, a raw material having a particle diameter (D₅₀) of roughly 0.1 mm to 1 mm is preferably used.

An example of a vertical type synthesizing apparatus 1 for synthesizing a molybdenum oxychloride is shown in Fig. 1. Note that the apparatus diagram is a schematic diagram and the size, shape, connection and arrangement of the respective parts are not limited thereto, and may be suitably changed. Moreover, a valve or flow control apparatus may be provided to the path of the gas piping as needed.

The vertical type synthesizing apparatus 1 mainly comprises a reaction chamber 3, an impurity trap 6, a recovery chamber 8, and a recovery container 9, and the reaction chamber 3 comprises a reaction container 2, a gas supply tube 4, a raw material supply tube 5, and a thermocouple 10. Moreover, the impurity trap 6 internally comprises a physical filter 7.

The synthesizing method is now explained. Foremost, a MoO₃ powder is supplied to the reaction container 2, and heated at 700 to 1000°C. Moreover, when the MoO₃ raw material is consumed due to the synthesis and results in the decrease of MoO₃, the raw material may be injected from the raw material supply tube 5 as needed. Subsequently, chloridation is performed by supplying chlorine gas from the gas supply tube 4 to the MoO₃ reaction container 2. Here, Ar gas may also be introduced as a carrier gas.

MoO₃ reacts with Cl₂ due to the introduction of a chlorine gas or the like and, for example, MoO₂Cl₂ is generated under the reaction formula of MoO₃ + Cl₂ → MoO₂Cl₂ + 0.5O₂. Otherwise, MoOCl₂, MoOCl₃, and MoOCl₄ of different levels of chloridation may also be generated. The generated molybdenum oxychloride is discharged as a gas.

The molybdenum oxychloride gas obtained based on the foregoing synthesis reaction reaches the recovery chamber 8 via the impurity trap 6. Here, while impurities such as tungsten and iron are gasified as a chloride or an oxychloride and become diffused, by providing a temperature-controlled impurity trap 6, it is possible to prevent such impurities from getting mixed into the recovery chamber 8. The reason for this is considered to be because, since the flow rate of the gas decreases in the impurity trap, the impurities get trapped therein.

Moreover, the impurity trap 6 is preferably provided with a physical filter such as a glass filter or silica wool. It is thereby possible to prevent the inclusion of Na that becomes scattered as a solid. Furthermore, by also precipitating the impurities such as tungsten and iron, which were recovered with the impurity trap 6, to the physical filter, discharge of such impurities to the downstream side (recovery chamber) can be more effectively prevented. As the temperature in the impurity trap 6, temperature in which MoO₂Cl₂ remains in a state of gas becomes the lower limit and temperature in which impurity components often become a solid phase becomes the upper limit, and specifically the temperature is preferably maintained at 150°C to 250°C. Moreover, by changing the diameter and length of the impurity trap 6, the recovery efficiency and the removal rate of impurities can be suitably adjusted.

Subsequently, by cooling the molybdenum oxychloride gas from which impurities have been removed in the recovery chamber 8, the molybdenum oxychloride gas is precipitated as a solid phase of the molybdenum oxychloride. The recovery container 9 is connected to the lower part of the recovery chamber 8, and the recovery container 9 is able to recover the precipitates that could not be recovered or the precipitates that fell from the recovery chamber 8. Cooling can be performed via natural cooling. It is thereby possible to obtain the high-purity molybdenum oxychloride according to an embodiment of the present invention.

Note that an exhaust pipe that leads to a detoxifying device which discharges and detoxifies an unreacted chlorine or a sublime chloride or a vacuum pipe that leads to a vacuum pump for adjusting the pressure in the apparatus may be additionally connected to the recovery container.

### [Examples]

The present invention is now explained in detail based on Examples and Comparative Examples. The descriptions of the following Examples and Comparative Examples are merely specific examples for facilitating the understanding of the technical subject matter of the present invention, and the technical scope of the present invention is not limited to such specific examples.

### (Example 1)

After filling a MoO₃ raw material in a reaction container, the reaction container was heated at 800°C, a chlorine gas was subsequently introduced from a gas supply tube and MoO₂Cl₂ was synthesized, gasified MoO₂Cl₂ was thereafter passed through an impurity trap (retained at 190°C) and then precipitated to a recovery chamber, and a solid phase MoO₂Cl₂ was recovered in a recovery container. While synthesis was basically performed using the apparatus shown in Fig. 1, in Example 1, the physical filter shown in Fig. 1 was not provided. The contents of the respective elements contained in the obtained MoO₂Cl₂ are shown in Table 1. As shown in Table 1, the purity of MoO₂Cl₂ is 99.9999 wt%, and a high-purity molybdenum oxychloride was obtained. Moreover, the W content was less than 0.1 wt ppm, and the Fe content was less than 0.1 wt ppm.

### (Example 2)

Synthesis was basically performed using the apparatus shown in Fig. 1. After filling a MoO₃ raw material in a reaction container, the reaction container was heated at 800°C, a chlorine gas was subsequently introduced from a gas supply tube and MoO₂Cl₂ was synthesized, gasified MoO₂Cl₂ was thereafter passed through an impurity trap (retained at 190°C, with silica wool) and then precipitated to a recovery chamber, and a solid phase MoO₂Cl₂ was recovered in a recovery container. The contents of the respective elements contained in the obtained MoO₂Cl₂ are shown in Table 1. As shown in Table 1, the purity of MoO₂Cl₂ is 99.9999 wt%, and a high-purity molybdenum oxychloride was obtained. Moreover, the W content was less than 0.1 wt ppm, and the Fe content was less than 0.1 wt ppm.

### (Example 3)

Synthesis was basically performed using the apparatus shown in Fig. 1. After filling a MoO₃ raw material in a reaction container, the reaction container was heated at 800°C, a chlorine gas was subsequently introduced from a gas supply tube and MoO₂Cl₂ was synthesized, gasified MoO₂Cl₂ was thereafter passed through an impurity trap (retained at 155°C, with silica wool) and then precipitated to a recovery chamber, and a solid phase MoO₂Cl₂ was recovered in a recovery container. The contents of the respective elements contained in the obtained MoO₂Cl₂ are shown in Table 1. As shown in Table 1, the purity of MoO₂Cl₂ exceeds 99.9999 wt%, and a high-purity molybdenum oxychloride was obtained. Moreover, the W content was less than 0.1 wt ppm, and the Fe content was less than 0.1 wt ppm.

### (Example 4)

Synthesis was basically performed using the apparatus shown in Fig. 1. After filling a MoO₃ raw material in a reaction container, the reaction container was heated at 900°C, a chlorine gas was subsequently introduced from a gas supply tube and MoO₂Cl₂ was synthesized, gasified MoO₂Cl₂ was thereafter passed through an impurity trap (retained at 190°C) and then precipitated to a recovery chamber, and a solid phase MoO₂Cl₂ was recovered in a recovery container. Moreover, in order to improve the recovery efficiency, in Example 4 the length of the impurity trap was shortened in comparison to the other Examples. The contents of the respective elements contained in the obtained MoO₂Cl₂ are shown in Table 1. As shown in Table 1, the purity of MoO₂Cl₂ is 99.9996 wt%, and a high-purity molybdenum oxychloride was obtained. Moreover, the W content was 2.1 wt ppm, and the Fe content was less than 0.1 wt ppm.

### (Example 5)

Synthesis was basically performed using the apparatus shown in Fig. 1. After filling a MoO₃ raw material in a reaction container, the reaction container was heated at 900°C, a chlorine gas was subsequently introduced from a gas supply tube and MoO₂Cl₂ was synthesized, gasified MoO₂Cl₂ was thereafter passed through an impurity trap (retained at 190°C) and then precipitated to a recovery chamber, and a solid phase MoO₂Cl₂ was recovered in a recovery container. The contents of the respective elements contained in the obtained MoO₂Cl₂ are shown in Table 1. As shown in Table 1, the purity of MoO₂Cl₂ is 99.9998 wt%, and a high-purity molybdenum oxychloride was obtained. Moreover, the W content was 0.8 wt ppm, and the Fe content was less than 0.1 wt ppm.

### (Comparative Example 1)

After filling a MoO₃ raw material in a reaction container, the reaction container was heated at 800°C, a chlorine gas was subsequently introduced from a gas supply tube and MoO₂Cl₂ was synthesized, gasified MoO₂Cl₂ was thereafter precipitated to a recovery part, and a solid phase MoO₂Cl₂ was recovered in a recovery container. While synthesis was basically performed using the apparatus shown in Fig. 1, in Comparative Example 1, the impurity trap 6 (and physical filter 7) shown in Fig. 1 was not provided. The contents of the respective elements contained in the obtained MoO₂Cl₂ are shown in Table 1. As shown in Table 1, the purity of MoO₂Cl₂ is less than 99.999 mass%, the content of W as an impurity was 17 wt ppm, and the content of Fe as an impurity was 30 wt ppm.

The foregoing results are summarized in Table 1.

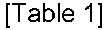

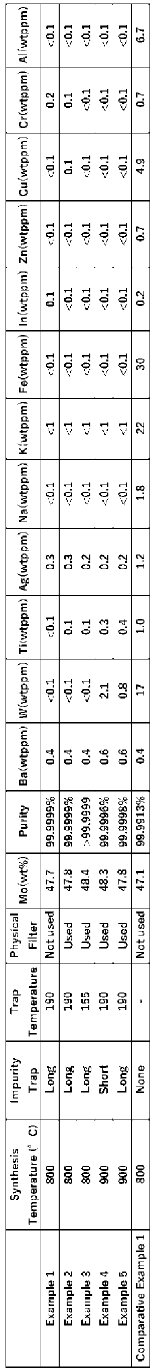

### [Industrial Applicability]

The present invention is able to reduce impurities, which were particularly difficult to remove in the past, in the synthesis of a molybdenum oxychloride, and obtain a high-purity molybdenum oxychloride. Thus, the present invention is able to make a significant technical contribution to industrial and technical fields such as the semiconductor industry, electronic device manufacture, functional material production, and organic/inorganic chemical industry which use a high-purity molybdenum oxychloride as the raw material or catalyst in CVD or ALD, and form thin films or synthesize compounds.

### [Description of Reference Numerals]

1 synthesizing apparatus
2 reaction container
3 reaction chamber
4 gas supply tube
5 raw material supply tube
6 impurity trap
7 physical filter
8 recovery chamber
9 recovery container
10 thermocouple

## Claims

1. A molybdenum oxychloride **characterized in** having a purity of 99.9995 wt% or higher, wherein a K content or a W content is less than 1 wt ppm.

2. The molybdenum oxychloride according to claim 1, wherein the W content is less than 0.1 wt ppm.

3. The molybdenum oxychloride according to claim 1 or 2, wherein an Fe content is less than 0.1 wt ppm.

4. The molybdenum oxychloride according to claim 1 to 3, wherein a Na content is less than 0.1 wt ppm.

5. The molybdenum oxychloride according to claim 1 to 4, wherein the molybdenum oxychloride includes one type among MoOCl₂, MoOCl₃, MoOCl₄, and MoO₂Cl₂.

## Patentansprüche

1. Molybdänoxychlorid, **dadurch gekennzeichnet, dass** es eine Reinheit von 99,9995 Gew.-% oder höher aufweist, wobei ein K-Gehalt oder ein W-Gehalt weniger als 1 Gew.-ppm beträgt.

2. Molybdänoxychlorid nach Anspruch 1, wobei der W-Gehalt weniger als 0,1 Gew.-ppm beträgt.

3. Molybdänoxychlorid nach Anspruch 1 oder 2, wobei ein Fe-Gehalt weniger als 0,1 Gew.-ppm beträgt.

4. Molybdänoxychlorid nach Anspruch 1 bis 3, wobei ein Na-Gehalt weniger als 0,1 Gew.-ppm beträgt.

5. Molybdänoxychlorid nach einem der Ansprüche 1 bis 4, wobei das Molybdänoxychlorid eines von MoOCl₂, MoOCl₃, MoOCl₄ und MoO₂Cl₂ einschließt.

## Revendications

1. Oxychlorure de molybdène **caractérisé en ce qu'**il a une pureté de 99,9995 % en poids ou plus, dans lequel une teneur en K ou une teneur en W est inférieure à 1 ppm en poids.

2. Oxychlorure de molybdène selon la revendication 1, dans lequel la teneur en W est inférieure à 0,1 ppm en poids.

3. Oxychlorure de molybdène selon la revendication 1 ou 2, dans lequel une teneur en Fe est inférieure à 0,1 ppm en poids.

4. Oxychlorure de molybdène selon la revendication 1 à 3, dans lequel une teneur en Na est inférieure à 0,1 ppm en poids.

5. Oxychlorure de molybdène selon la revendication 1 à 4, dans lequel l'oxychlorure de molybdène comporte un type parmi MoOCl₂, MoOCl₃, MoOCl₄, et MoO₂Cl₂.
